# FASCICULE DE BREVET EUROPEEN

(11) **EP 2 397 530 B1**
(45) Date de publication et mention de la délivrance du brevet: **09.01.2013**
(21) Numéro de dépôt: 11354033.0
(22) Date de dépôt: 14.06.2011
(51) Int. Cl.: C09J 5/00

(54) **Procédé de collage calibré en épaisseur entre au moins deux substrats**
Dickenkalibriertes Klebeverfahren zwischen mindestens zwei Substraten
Gluing method with calibrated thickness between at least two substrates

(30) Priorité: 18.06.2010 FR 1002584
(43) Date de publication de la demande: 21.12.2011
(73) Titulaire: Commissariat à l'Énergie Atomique et aux Énergies Alternatives, 75015 Paris (FR)
(72) Inventeur: Ait-Mani, Abdenacer, 38120 Saint-Egrève (FR)
(74) Mandataire: Dubreu, Sandrine

(56) Documents cités:
- DE-B3-102006 053 916
- FR-A1- 2 856 047
- FR-A1- 2 921 201

## Description

### Domaine technique de l'invention

L'invention concerne un procédé de collage entre au moins deux substrats comprenant :
- une étape de dépôt d'au moins une goutte de colle liquide, sur un des deux substrats
- et une étape de mise en contact des deux substrats provoquant l'étalement de la colle liquide suivi de la formation, entre les deux substrats, d'une couche de colle solidifiée.

### État de la technique

Comme indiqué dans la demande de brevet US-A-2004/0009649, il existe plusieurs techniques de collage dans le domaine de la microélectronique, pour assembler au moins deux substrats entre eux, tels que des plaquettes en matériaux semi-conducteurs, également connues sous le nom anglo-saxon de « wafers ». En particulier, l'assemblage peut être réalisé par collage direct, par exemple de type moléculaire (« atom-to-atom bonding »), avec une couche mince adhésive (« Direct wafer bonding with thin bonding material layer ») ou un métal (« metal direct bonding »). Une autre technique consiste à réaliser un collage par l'intermédiaire d'une couche de colle disposée à l'interface entre les deux substrats à assembler. La couche de colle est, en général, organique et plus particulièrement en matériau polymère (« polymer wafer bonding »), mais elle peut aussi être inorganique dans certains cas.

Le collage à l'aide d'une couche de colle consiste, en particulier, à former à l'interface entre les deux substrats à assembler une couche en polymère, par exemple en PMMA, en polyimide ou en BCB. L'assemblage des deux substrats est, le plus souvent, réalisé en appliquant une pression sur l'un et/ou sur l'autre des substrats lors de leur mise en contact et il peut être suivi d'une étape de recuit pour augmenter la résistance de collage.

Cependant, un des principaux problèmes rencontrés dans les procédés de collage utilisant une couche de colle organique ou inorganique est lié à la difficulté de maîtriser la quantité de colle déposée et donc de contrôler l'épaisseur finale de la couche de colle sur toute l'interface. En effet, il est fréquent de déposer une quantité de colle supérieure à celle nécessaire pour former une couche de colle d'une épaisseur prédéterminée. Or, l'excès de colle déposé a tendance, après l'assemblage, à être évacué sur tout le périmètre de la zone collée, ce qui génère une inhomogénéité d'épaisseur à l'interface de collage entre le centre et la périphérie de l'interface. De plus, lorsqu'une pression est appliquée sur l'un et/ou sur l'autre des substrats, notamment dans le cas de pièces de grande surface, il peut être difficile de répartir uniformément la pression nécessaire sur toute la surface à coller, ce qui engendre également des collages défectueux.

À titre d'exemple, la demande de brevet FR-A-2798935 propose un procédé de collage de deux surfaces permettant d'assurer un collage uniforme, sans risque d'endommager les pièces à coller en appliquant une pression lors de l'assemblage des deux surfaces. En particulier, le procédé proposé dans la demande de brevet FR-A-2798935 consiste à former une cavité située entre les deux surfaces à coller au moyen d'un cordon de colle, à rendre la cavité étanche et à produire une différence de pression positive entre la pression environnante régnant dans la zone extérieure à la cavité et la pression régnant dans la cavité, grâce à une ouverture ménagée dans au moins l'une des surfaces. Ainsi, les pièces à coller sont mises en contact l'une sur l'autre, sous l'effet de la différence de pression produite. Cette technique nécessite, cependant, de pouvoir parfaitement contrôler la quantité de colle déposée sous la forme d'un cordon de colle ainsi que l'agencement du cordon de colle, pour obtenir un collage uniforme et sans défaut.

La demande de brevet FR-A-2921201 propose un procédé de collage collectif de puces individuelles sur un substrat commun permettant d'obtenir un film de colle homogène et sans bulle. En particulier, le procédé proposé dans la demande de brevet FR-A-2921201 comprend les étapes suivantes :
- la disposition de couches fonctionnalisées ou actives sur un support de manière adjacentes non contiguë, avec un espacement entre deux couches voisines,
- le dépôt d'une goutte de colle calibrée sur chacune des couches fonctionnalisées,
- le report d'un substrat de contrainte sur ces gouttes de colle,
- et la singularisation des parties de l'ensemble ainsi formé pour réaliser des puces collées sur le substrat de contrainte.

Ainsi, la disposition des couches fonctionnalisées les unes par rapport aux autres crée des canaux s'apparentant à des réservoirs permettant de piéger localement les bulles. Cependant, comme indiqué plus haut, un tel procédé ne permet pas de contrôler l'épaisseur finale du film de colle après l'étape de recuit, sur une couche fonctionnalisée mais aussi d'une couche fonctionnalisée à l'autre.

Par ailleurs, la société DISCO ABRASIVE SYSTEMS LTD a mis au point un procédé appelé « procédé TAIKO » dans lequel le polissage arrière (« backgrinding ») est réalisé d'une manière différente des méthodes conventionnelles de polissage arrière. En particulier, lors du polissage de la face arrière d'une plaquette semi-conductrice, celui-ci est réalisé de manière à laisser un rebord non poli d'environ 2mm sur la face arrière de la plaquette. La présence d'un tel rebord est destinée à diminuer les risques liés à la manipulation des plaquettes minces et les risques de déformation de la surface plane des plaquettes également connus sous le nom de gauchissement ou « warpage » en anglais. Une fois le polissage arrière réalisé et comme indiqué dans la demande de brevet JP2009081391, un liant est disposé dans la zone délimitée par le rebord non poli, la surface de la face arrière comprenant le rebord et le matériau adhésif est rendue plane, avant d'être disposée sur un élément, appelé ruban de découpage, maintenu par un cadre périphérique annulaire métallique et ce, dans le but de découper la plaquette en une pluralité de puces.

### Objet de l'invention

L'invention a pour but de proposer un procédé de collage entre au moins deux substrats et plus particulièrement entre au moins deux substrats en matériaux semi-conducteurs, remédiant aux inconvénients de l'art antérieur. En particulier, l'invention a pour but de proposer un procédé de collage entre au moins deux substrats comprenant :
- une étape de dépôt d'au moins une goutte de colle liquide, sur un des deux substrats
- et une étape de mise en contact des deux substrats provoquant l'étalement de la colle liquide suivi de la formation, entre les deux substrats, d'une couche de colle solidifiée, ladite couche de colle solidifiée obtenue étant sans défaut et d'une épaisseur uniforme et maîtrisée.

Selon l'invention, ce but est atteint par les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 et 2 représentent, schématiquement et en coupe, les différentes étapes d'un mode particulier de réalisation d'un procédé de collage entre deux substrats, tandis que la figure 3 représente une vue de dessus du substrat massif muni d'un rebord périphérique.
- les figures 4 à 13 représentent, schématiquement et en coupe, différentes étapes de réalisation pour coller un substrat massif à une pluralité de substrats coplanaires amincis, tandis que la figure 14 illustre en vue de dessus la pluralité de substrats coplanaires amincis, munis de rebords périphériques tels qu'avantageusement obtenus selon la figure 10.
- les figures 15 à 19 représentent, schématiquement et en coupe, différentes étapes de réalisation pour coller un substrat à une pluralité de substrats coplanaires amincis tandis que la figure 20 illustre en vue de dessus le substrat muni de rebords tel qu'illustré sur la figure 16.

### Description de modes particuliers de réalisation

Il est proposé de contrôler l'épaisseur de la couche de colle solidifiée, formée entre au moins deux substrats pour les coller l'un à l'autre, en munissant un des deux substrats d'un rebord, faisant saillie en surface et dans lequel est formée au moins une fente également appelée évent. Un tel rebord délimite l'espace de collage, c'est-à-dire l'espace dans lequel est formée et disposée une couche de colle solidifiée, une fois les substrats mis en contact.

Ainsi, le rebord est, avantageusement, formé en surface de l'un des substrats, par une nervure formant un pourtour clos, à l'exception de la ou des fentes ménagées dans ledit rebord. Il délimite alors dans la surface dudit substrat, un logement (ou une cavité) destiné à former l'espace de collage lorsque les substrats sont mis en contact. Le rebord présente, de plus, une hauteur particulière, choisie selon l'épaisseur souhaitée pour la couche de colle solidifiée disposée dans ledit espace de collage. Cette hauteur est, avantageusement, constante.

Par ailleurs, le volume de colle liquide déposé sur l'un des deux substrats est supérieur au volume de l'espace de collage. Ainsi, l'excès de colle liquide peut être évacué par la fente formée dans le rebord, lors de la mise en contact des deux substrats au lieu de passer par-dessus ledit rebord. De plus, la goutte de colle liquide déposée sur l'un ou l'autre des substrats présente une hauteur strictement supérieure à la hauteur du rebord. Ainsi, lorsque les substrats sont mis en contact, la goutte de colle déposée sur l'une des deux substrats est le premier élément à entrer en contact avec l'autre substrat, avant le rebord. De plus, grâce au phénomène de capillarité, la colle liquide présente une bonne mouillabilité dans l'espace de collage et notamment à proximité du rebord délimitant ledit espace de collage. L'étalement de la colle liquide dans l'espace de collage est alors réalisé de manière automatique lorsque la goutte de colle entre en contact avec l'autre substrat. Avantageusement, la hauteur de la goutte de colle est 10 fois supérieure à la hauteur du rebord. De plus, les dimensions de la fente réalisée dans le rebord sont, avantageusement, choisies en fonction du type de colle utilisé et notamment en fonction de la viscosité de la colle. Plus la viscosité de la colle est élevée, plus les dimensions de la fente sont grandes. Pour une colle de type époxy, la fente présente, avantageusement, une largeur supérieure ou égale à 10µm et une hauteur supérieure ou égale à 2µm, ce qui permet d'obtenir une fente ayant une surface de 20µm² pour une colle présentant une viscosité de l'ordre de 200 à 300cPo.

Il est, alors, possible d'obtenir une couche de colle solidifiée d'une épaisseur uniforme sur toute l'interface de collage et sans défaut. Avantageusement, la couche de colle solidifiée présente une épaisseur de l'ordre de quelques micromètres, typiquement entre 1µm et 3µm, sur quasiment toute l'interface entre les deux substrats, qui peut varier de quelques millimètres carrés à quelques centimètres carrés.

Par ailleurs, le rebord faisant saillie en surface d'au moins un substrat permet de rigidifier ledit substrat. C'est notamment utile lorsque le substrat est muni en face arrière d'un film de maintien souple, afin de limiter l'influence de celui-ci et, plus particulièrement, l'influence de l'ondulation que ce film de maintien souple peut générer. Dans ce cas, l'uniformité de l'épaisseur de la couche de colle ne dépend que de l'état de surface (état de planéité) du substrat qui sera rapporté sur le substrat muni du rebord. En effet, si le substrat muni d'un film de maintien ne comporte pas de rebord, l'ondulation du film de maintien engendre une ondulation du substrat qui elle-même engendrera une ondulation de la couche de colle. Dans ce cas, il n'est pas possible d'obtenir un film de colle uniforme, même avec un substrat rapporté parfaitement plan.

Un tel procédé de collage peut s'appliquer à différents types de substrats, plus particulièrement à des substrats à base de matériaux semi-conducteurs utilisés dans le domaine de la microélectronique, par exemple des plaquettes circulaires connues sous le nom anglo-saxon de « wafers ». Chaque substrat est alors formé principalement par un matériau semi-conducteur, tel que le silicium. De plus, ils peuvent être des substrats massifs, avec, par exemple une épaisseur comprise entre 500µm et 1000µm ou bien ils peuvent être amincis par tout type de techniques connues dans le domaine de la microélectronique, avec, par exemple, une épaisseur finale comprise entre 15µm et 35µm. Par ailleurs, l'un et/ou l'autre des substrats peuvent, de plus, être passifs, c'est-à-dire sans composant et/ou actifs, c'est-à-dire avec un circuit microélectronique tel qu'un circuit Cmos. Enfin, les substrats peuvent être, de manière classique, chacun reportés sur une couche de protection, par exemple en pyrex, et dont le coefficient d'expansion thermique est équivalent à celui du matériau semi-conducteur formant le substrat correspondant. Ils ont, par exemple, un diamètre compris entre 100mm et 300mm.

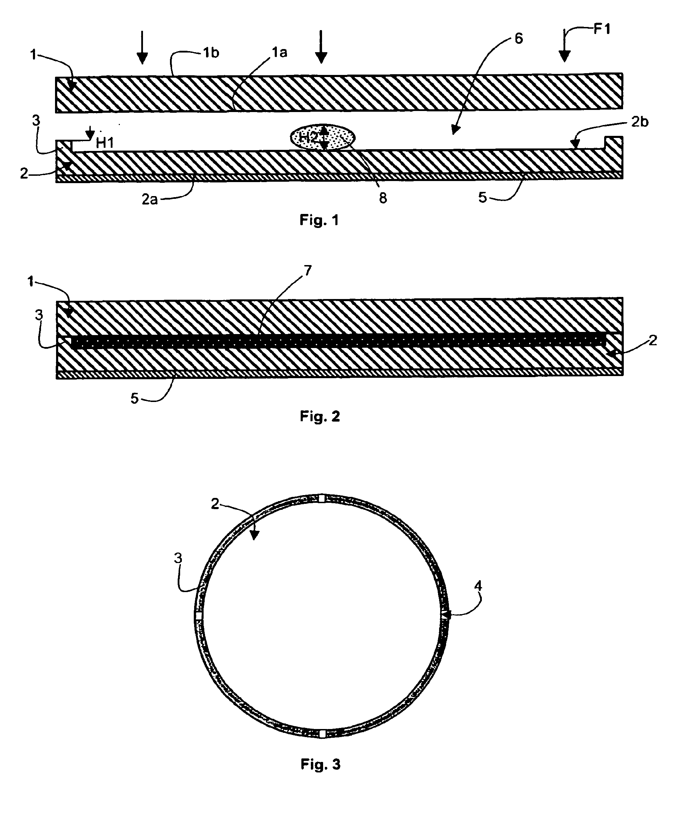

Selon un mode particulier de réalisation représenté sur les figures 1 à 3, deux substrats 1 et 2, par exemple en silicium, sont collés l'un à l'autre.

Le substrat portant la référence 2 sur les figures 1 à 3, est muni d'un rebord 3, faisant saillie et dans lequel sont formées quatre fentes 4 réparties uniformément. De plus, le rebord 3 est, dans ce mode de réalisation, un rebord périphérique, c'est-à-dire un rebord disposé en périphérie de la surface 2b du substrat 2, afin d'obtenir un espace de collage ayant le plus grand volume possible.

La réalisation du rebord 3 peut être obtenue par tout type de techniques classiquement utilisées dans le domaine de la microélectronique. Ainsi, le rebord 3 peut, par exemple, être réalisé en protégeant préalablement la face 2a du substrat 2 opposée à la face dans laquelle sera réalisé le rebord 3, par exemple par dépôt d'un film mince de protection 5 formé par un matériau adhésif souple (type acrylique, colle sensible aux rayonnements UV et qui ne nécessite pas de montée en température ou encore résine de collage temporaire réticulée, telle que celle commercialisée par la société Brewer réticulée). Le substrat 2 est, ensuite, retourné, afin de réaliser, dans la face 2b, le rebord 3 muni d'au moins une fente 4. Le rebord peut, par exemple, être réalisé par une opération de gravure sèche ou humique, à travers un masque en résine photosensible préalablement réalisé par photolithographie. Le masque est, ensuite, retiré. Il pourrait aussi être réalisé par gravure à l'aide d'un faisceau laser afin d'éliminer les parties du substrat non protégées par le masque préalablement réalisé.

Sur la figure 1, le rebord périphérique 3 délimite alors, dans le substrat 2, un logement ou une cavité 6, dont le fond est sensiblement plan. Par ailleurs, la hauteur H1 du rebord 3, par rapport au fond du logement 6, est maîtrisée lors de la réalisation dudit rebord afin de correspondre à l'épaisseur souhaitée pour la couche de colle finale 7, destinée à assurer le collage entre les deux substrats 1 et 2, une fois celle-ci solidifiée. La maîtrise de la hauteur du rebord périphérique 3 est, par exemple, obtenue en contrôlant les paramètres de gravure dans l'exemple de réalisation du rebord mentionné ci-dessus.

De plus, sur la figure 1, une goutte de colle 8 liquide est déposée sur le substrat 2, dans le fond du logement 6, puis le substrat 1 est amené progressivement vers le substrat 2 (flèches F1), de manière à réaliser la mise en contact avec les deux substrats 1 et 2. Cette étape de mise en contact peut, par exemple, être réalisée à l'aide d'un banc d'assemblage.

La hauteur H2 de la goutte de colle 8 étant supérieure à la hauteur H1 du rebord 3, le substrat 1 entre d'abord en contact avec la goutte de colle 8 avant que sa surface 1 a, sensiblement plane, vienne reposer sur le rebord 3 périphérique du substrat 2. Ainsi, la mise en contact de la surface 1a du substrat 1 avec la goutte de colle liquide 8 provoque l'étalement de la colle liquide dans le logement 6. Par ailleurs, le ménisque créé au contact entre la surface 1a du substrat 1 et la goutte de colle liquide 8 permet, de manière avantageuse, de maîtriser l'étalement de la colle, de sorte que le substrat 1 repose sur le rebord 3 juste avant que la colle liquide en cours d'étalement n'arrive au niveau du rebord 3. De plus, la présence de fentes 4 permet à la colle en excès de s'évacuer par ces passages, plutôt que de passer par-dessus le rebord 3. Le rebord 3 peut être traité à l'aide d'un traitement de surface, afin de rendre sa surface supérieure hydrophobe à la colle. Ceci est, particulièrement, intéressant dans le cas d'une mauvaise planéité. Enfin, le fait que la surface 1 a du substrat 1 soit sensiblement plane, avec un très faible niveau de défaut de planéité permet d'assurer, de manière avantageuse, l'étanchéité de l'assemblage collé, sauf au niveau des fentes 4. À titre d'exemple, le défaut de planéité de la surface 1a du substrat 1 est de manière typique très inférieure à 10 µm pour un substrat d'un diamètre de 150 mm.

De plus, le volume de la goutte de colle liquide 8 est choisi de manière à être supérieur au volume de l'espace de collage. Ainsi, la présence des fentes 4 dans le rebord permet d'évacuer l'éventuel excès de colle liquide lors de la mise en contact entre les deux substrats 1 et 2, ce qui permet d'obtenir une couche de colle 7, une fois celle-ci solidifiée, d'une épaisseur uniforme dans le logement 6 (correspondant d'ailleurs à la hauteur H1 du rebord). Ainsi, les fentes 4 permettent à l'excès de colle liquide et aux bulles d'air, présents dans le logement 6 de s'échapper. Le volume de la goutte de colle liquide 8 n'a donc pas besoin d'être calibré avec une grande précision pour remplir sans excès le volume de l'espace de collage. Il peut être en excès, puisque c'est le volume de l'espace de collage associé à la présence de fentes ménagées dans le rebord 3 qui déterminent le volume final de colle et donc l'épaisseur de la couche de colle finale. De plus, la mise en contact des substrats peut être réalisée sans qu'il soit nécessaire d'exercer une pression sur l'un ou sur l'autre des substrats. Ceci est, particulièrement, intéressant, dans la mesure où l'application d'une pression sur l'un ou l'autre des substrats pendant leur mise en contact peut endommager physiquement les substrats eux-mêmes ou bien les composants ou circuits réalisés sur ces substrats (par exemple les billes de brasage réalisées sur les faces avant des substrats). Or, dans le procédé de collage selon les figures 1 à 3, la pression exercée par le poids du substrat 1 sur le substrat 2 est suffisante pour réaliser le collage.

La colle est, avantageusement, une colle organique telle qu'un époxy ou un polyimide, mais elle peut aussi être une colle inorganique tel qu'un silicone. Elle est déposée sous forme liquide, puis une fois les deux substrats mis en contact, elle est solidifiée sous la forme d'une couche solide 7 disposée à l'interface entre les deux substrats, dans l'espace délimité par le rebord, entre les deux substrats et également appelé espace de collage. Cet espace de collage correspond au logement 6 ménagé dans le substrat 2 lorsque les substrats 1 et 2 sont mis en contact l'un avec l'autre.

La solidification de la colle peut, avantageusement, être réalisée par une étape de réticulation, par exemple réalisée directement sur le banc d'assemblage des deux substrats, après un temps de relaxation sous vide permettant l'extraction des bulles d'air éventuelles dans l'espace de collage. Par exemple, la température de réticulation type pour une colle Epoxy est comprise entre la température ambiante et 150°C. Cette étape de réticulation peut être réalisée avec un couple Température-Temps adapté.

Dans ce mode de réalisation, la goutte de colle liquide 8 est déposée sur le substrat 2, qui est le substrat muni du rebord 3. Par contre, dans un mode de réalisation alternatif, elle pourrait aussi bien être déposée sur l'autre substrat, le substrat 1. Dans ce cas, la goutte de colle liquide 8 serait déposée sur la surface 1a du substrat 1, puis le substrat 2 muni du rebord 3 serait placé au-dessus du substrat 1, la face 2b munie du rebord 3 placée en vis-à-vis de la surface 1a du substrat 1 pour qu'elle soit reportée sur la surface 1a du substrat 1.

Le mode de réalisation représenté sur les figures 1 à 3 illustre un procédé de collage entre deux substrats. Par contre, comme illustré dans les deux modes réalisation ci-dessous, il est aussi possible de réaliser le collage de plusieurs substrats et notamment entre un premier substrat et une pluralité de substrats coplanaires séparés par au moins un chemin de découpe.

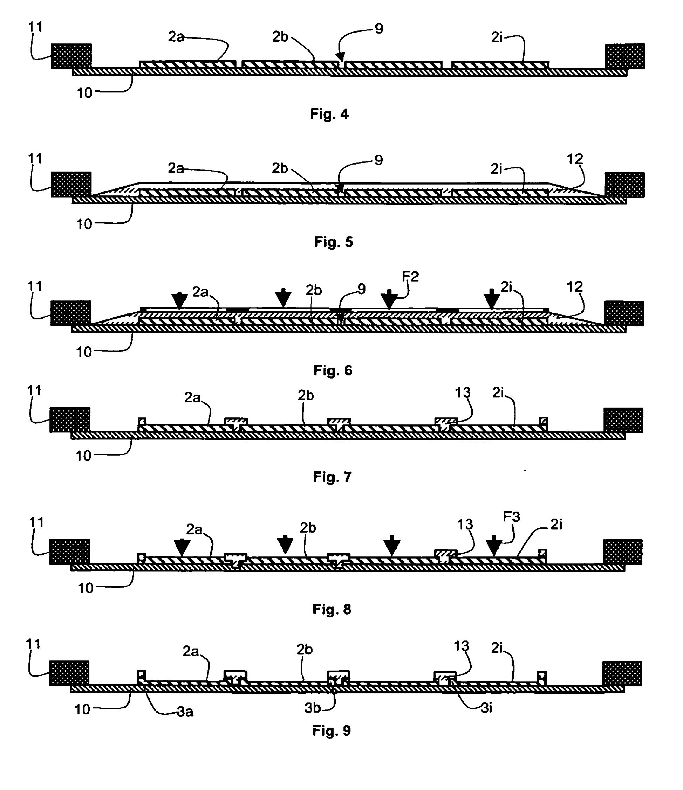

Ainsi, dans le mode de réalisation représenté sur les figures 4 à 14, un premier substrat 1, par exemple massif, est reporté par collage à une pluralité de seconds substrats 2a, 2b,...,2i coplanaires, séparés les uns des autres par un ou plusieurs chemins de découpe et avantageusement amincis. Dans chacun des seconds substrats est réalisé un rebord, plus particulièrement périphérique et muni d'au moins une fente.

Plus particulièrement, la pluralité de substrats 2a, 2b,...,2i coplanaires séparés par des chemins de découpe 9 est réalisée par tout type de techniques connues dans le domaine de la microélectronique. En particulier, elle peut être réalisée par un procédé de découpage également connu sous l'acronyme anglo-saxon DBG (pour « Dicing before Grinding » en anglais), à partir d'un substrat massif maintenu par un film support 10 à un cadre de maintien 11, plastique ou métallique. Le substrat massif subit une étape d'amincissement selon une profondeur légèrement supérieure à l'épaisseur finale souhaitée pour les seconds substrats 2a, 2b,...,2i, puis les chemins de découpe 9 sont réalisés afin de délimiter et isoler les seconds substrats 2a, 2b,...,2i les uns des autres, comme représenté sur la figure 4. À titre d'exemple, pour une épaisseur finale de 30µm, la profondeur de découpe réalisée pendant l'étape d'amincissement est comprise entre 35µm et 40µm. De plus, le transfert du substrat massif à amincir sur le film support 10 peut être réalisé par laminage simultané de ce film sur le cadre de maintien 11 et sur la face avant du substrat massif.

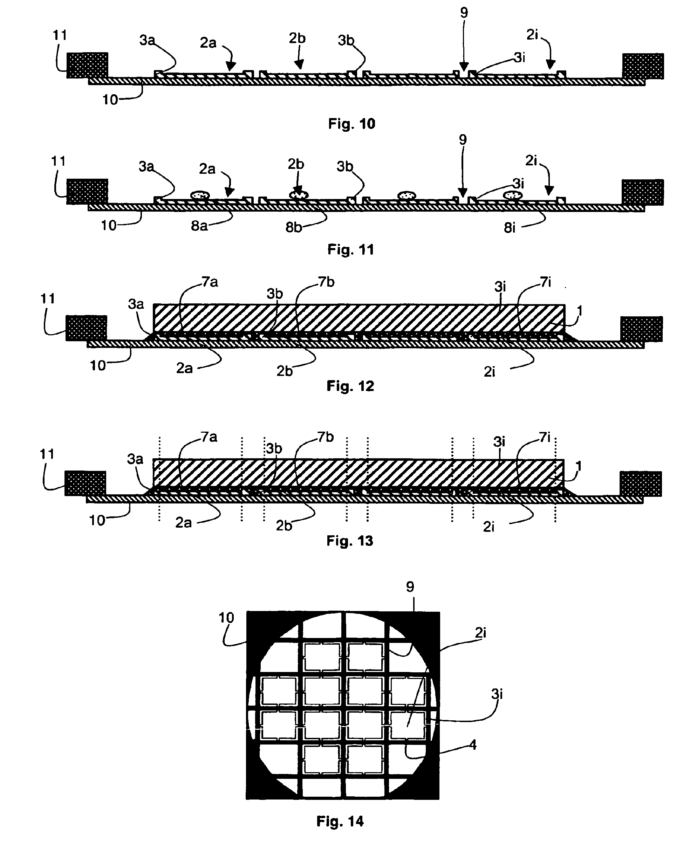

Ensuite, comme illustré sur les figures 5 à 10, un rebord 3a, 3b,...3i est réalisé à la périphérie de chacune des faces libres des substrats 2a, 2b,...,2i. Plus particulièrement, une couche en résine photosensible 12 est déposée par exemple par pulvérisation, sur les faces libres de substrats 2a, 2b,...,2i (figure 5) afin de réaliser un masque de gravure 13 par photolithographie (flèches F2 sur la figure 6). Le masque de gravure 13 recouvre une zone périphérique sur chaque face des substrats 2a, 2b,...,2i, ladite zone correspondant à l'emplacement destiné à former chaque rebord périphérique 3a, 3b,...3i. Le masque de gravure comble, de plus, les chemins de découpe 9. Une fois la résine développée (figure 7), l'étape de gravure localisée à travers le masque de gravure 13 (flèches F3 sur la figure 8) est réalisée afin de retirer sur une profondeur déterminée (correspondant à la hauteur souhaitée pour les rebords), une partie de chaque substrat non recouverte par le masque de gravure 13 (figure 9). Cette opération permet de former les rebords 3a, 3b,...3i avec leurs fentes 4. L'étape de gravure peut être réalisée par voie humide ou gazeuse ou par gravure laser. Ensuite, le masque de gravure 13 est retiré (figure 10).

La figure 14 illustre un exemple particulier de réalisation d'une pluralité de substrats 2a, 2b,...2i coplanaires, de section rectangulaire, séparés les uns des autres par des chemins de découpe 9. Dans chaque substrat est formé un rebord périphérique 3a, 3b, 3i muni de 4 fentes 4, chacune disposée au milieu d'un côté dudit rebord périphérique. Le nombre de fentes 4 peut, cependant, varier d'un mode de réalisation à un autre, avantageusement entre 1 à 4. De plus, les fentes 4 peuvent être traversantes ou non. Les rebords périphériques 3a, 3b,...3i ont tous avantageusement la même hauteur.

De la même manière que dans le précédent mode de réalisation, une fois les rebords réalisés dans chacun des seconds substrats 2a, 2b,...,2i, une goutte de colle liquide 8a, 8b,...,8i est déposée dans le fond de chaque logement 5a, 5b,...,5i délimité par chacun des rebords 3a, 3b,...3i. Puis le substrat 1 massif est reporté sur l'ensemble formé par la pluralité de substrats 2a, 2b,...,2i de sorte que la surface 1a du substrat 1 vienne en premier lieu en contact avec les gouttes de colle 8a, 8b,...,8i avant de reposer sur les rebords 3a, 3b,...3i. L'éventuel excès de colle liquide ainsi que les bulles éventuellement présentes dans les logements délimités par les rebords 3a, 3b,...,3i peuvent s'échapper de l'espace de collage par les fentes 4 et l'excès de colle liquide peut s'écouler dans les chemins de découpe 9, comme illustré sur la figure 12. Une fois les couches de colle 7a, 7b,...7i solidifiées, par exemple par une étape de traitement thermique, une opération de découpe peut être réalisée afin de séparer les substrats 2a,2b,...,2i les uns des autres. Les traits en pointillés sur la figure 13 illustrent une stratégie particulière de découpe consistant à supprimer le rebord périphérique de chaque substrat. Par contre, selon une alternative, le choix de conserver ces rebords périphériques peut aussi être envisagé.

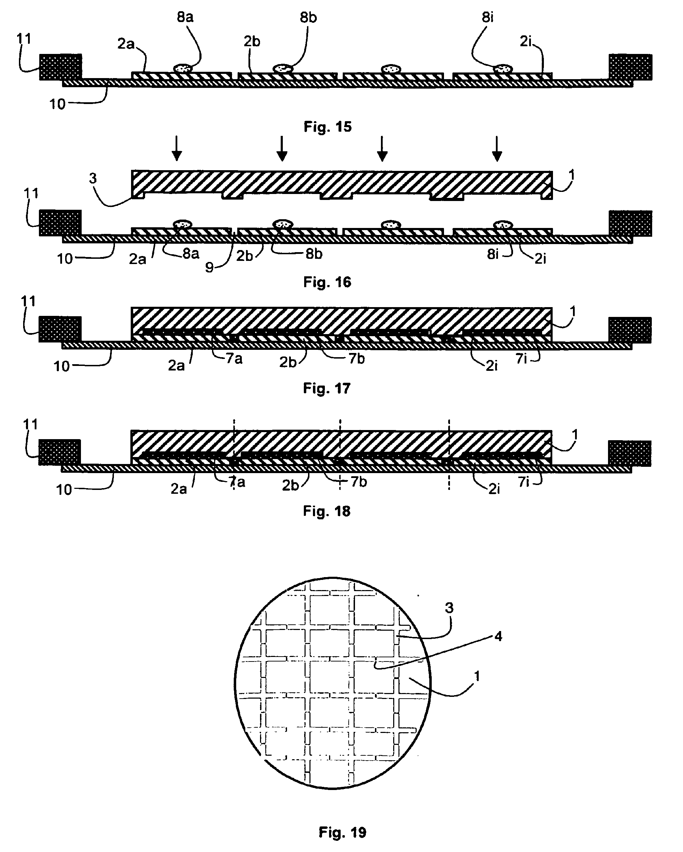

Dans le troisième mode de réalisation illustré sur les figures 15 à 19, un premier substrat 1, avantageusement massif, est aussi collé à une pluralité de substrats 2a, 2b,...2i coplanaires, avantageusement amincis et séparés par un ou plusieurs chemins de découpe 9. Par contre, dans ce cas, les rebords munis chacun d'au moins une fente et destinés à délimiter les espaces de collage pour les couches de colle solidifiée sont réalisés non pas sur chacun des substrats 2a, 2b,...2i, mais en surface 1a du premier substrat massif 1. Ils sont plus particulièrement obtenus en réalisant des nervures dans la surface 1a du premier substrat 1. La disposition des nervures est choisie de manière contrôlée, à des emplacements particuliers, afin qu'après collage et éventuellement découpe, il se forme un rebord correspondant à la périphérie de chaque second substrat 2a, 2b,...,2i.

À titre d'exemple, la figure 19 illustre un mode particulier de réalisation d'un substrat massif 1 muni en surface d'une pluralité de nervures destinées à former des rebords 3 chacun munis de fentes 4. Ainsi, le substrat 1 comprend en surface une pluralité de rebords 3 munis chacun de 4 fentes 4, chacune disposée au milieu d'un côté d'un rebord qui a sur la figure 20 une section rectangulaire. Le nombre de fentes 4 peut, cependant, varier d'un mode de réalisation à un autre, avantageusement entre 1 à 4. De plus, les fentes 4 peuvent être traversantes ou non. Les rebords 3 ont aussi, avantageusement, tous la même hauteur.

Une fois les rebords 3 réalisés, une goutte de colle liquide 8a, 8b,...,8i est déposée, dans ce mode de réalisation, sur chaque surface libre et sensiblement plane des substrats 2a, 2b,...,2i. Puis, le substrat 1 massif est reporté sur l'ensemble formé par la pluralité de substrats 2a, 2b,...,2i de sorte que la surface 1a du substrat 1 comprenant les rebords 3 vienne en premier lieu en contact avec les gouttes de colle 8a, 8b,...,8i avant de reposer sur les rebords 3a, 3b,...3i (figures 16 et 17). Comme dans le mode de réalisation précédent, l'éventuel excès de colle liquide ainsi que les bulles éventuellement présentes dans les espaces de collage ont la possibilité de pouvoir s'échapper desdits logements par l'intermédiaire des fentes 4. Dans ce cas, l'excès de colle liquide peut se déverser dans les chemins de découpe. Une fois la colle solidifiée 7a, 7b,...7i, par exemple par une étape de traitement thermique, une opération de découpe peut être réalisée afin de séparer les substrats 2a,2b,...,2i les uns des autres. Les traits en pointillés sur la figure 18 illustrent une stratégie particulière de découpe consistant à suivre les chemins de découpe de sorte que chaque ensemble formé par une partie du premier substrat 1 et un second substrat 2a, 2b,...ou 2i conserve un rebord qui devient, après la découpe, périphérique. Par contre, dans une alternative, l'opération de découpe pourrait être réalisée de manière à supprimer les rebords 3.

L'invention n'est pas limitée aux modes de réalisation décrits ci-dessus. En particulier, les fentes ménagées dans un rebord peuvent être sous forme de passages traversant ledit rebord, depuis sa surface libre destinée à venir en contact avec l'autre substrat jusqu'au fond du logement délimité par ledit rebord. Ainsi, dans ce cas, les fentes présentent une longueur égale à la hauteur du rebord. Selon une alternative, elles peuvent aussi être plus courtes. Par contre, elles sont alors toujours réalisées depuis la surface libre destinée à venir en contact avec l'autre substrat. De plus, un traitement d'activation à base de plasma oxygène peut, par exemple, être réalisé avant le dépôt de la colle et de préférence, sur les deux surfaces destinées à être mises en contact, afin de favoriser la qualité de l'adhérence à l'interface de collage. Par ailleurs, il est aussi possible de réaliser un dépôt anti-mouillant vis-à-vis de la colle, réalisé de manière sélective sur le rebord, afin d'éviter un ajout d'un film de colle supplémentaire à celui réalisé par la cavité. Ceci est particulièrement intéressant lorsque le dépôt initial de colle est en excès.

## Revendications

1. Procédé de collage entre au moins deux substrats (1, 2, 2a, 2b,...,2i) comprenant :
- une étape de dépôt d'au moins une goutte de colle liquide (8, 8a, 8b,...,8i), sur un des deux substrats (1, 2, 2a, 2b,...,2i)
- et une étape de mise en contact des deux substrats (1, 2, 2a, 2b,...,2i) provoquant l'étalement de la colle liquide suivi de la formation, entre les deux substrats (1, 2, 2a, 2b,...,2i), d'une couche de colle solidifiée (7, 7a, 7b,...,7i), **caractérisé:**
- **en ce qu'**un des deux substrats (1, 2, 2a, 2b,...,2i) est muni, en surface, d'au moins un rebord (3, 3a, 3b,...,3i) faisant saillie et dans lequel est formée au moins une fente (4),
- et **en ce que** le volume de colle liquide déposé sur l'un des deux substrats (1, 2, 2a, 2b,...,2i) est supérieur au volume de l'espace de collage, délimité par ledit rebord (3, 3a, 3b,...,3i) lorsque les substrats (1, 2, 2a, 2b,...,2i) sont mis en contact, de sorte que l'excès de colle liquide soit évacué par la fente (4) formée dans le rebord (3, 3a, 3b,...,3i), lors de la mise en contact des deux substrats (1, 2, 2a, 2b,...,2i), la goutte de colle liquide (8, 8a, 8b,...,8i) déposée sur l'un des deux substrats (1, 2, 2a, 2b,...,2i) présentant en outre une hauteur (H2) strictement supérieure à la hauteur (H1) du rebord (3, 3a, 3b,...,3i).

2. Procédé selon la revendication 1, **caractérisé en ce que** l'étape de mise en contact des deux substrats (1, 2, 2a, 2b,...,2i) est réalisée sans exercer de pression sur l'un ou sur l'autre des substrats (1, 2, 2a, 2b,...,2i).

3. Procédé selon l'une des revendications 1 à 2, **caractérisé en ce que** le dépôt d'au moins une goutte de colle liquide est réalisé sur le substrat (1, 2, 2a, 2b,...,2i) muni dudit rebord (3, 3a, 3b,...,3i).

4. Procédé selon l'une des revendications 1 à 2, **caractérisé en ce que** le dépôt d'au moins une goutte de colle liquide est réalisé sur le substrat (1, 2, 2a, 2b,...,2i) non muni dudit rebord.

5. Procédé selon l'une quelconque des revendications 1 à 4, **caractérisé en ce que** le procédé est un procédé de collage entre un premier substrat (1) et une pluralité de seconds substrats ( 2a, 2b,...,2i) coplanaires séparés par au moins un chemin de découpe (9).

6. Procédé selon la revendication 5, **caractérisé en ce que** ledit rebord (3) est formé en surface du premier substrat (1).

7. Procédé selon la revendication 5, **caractérisé en ce que** chaque second substrat (2a, 2b,...,2i) comporte, en surface, un rebord (3a, 3b,...,3i) faisant saillie et dans lequel est formée au moins une fente (4), ledit rebord (3a, 3b,...,3i) étant disposé en périphérique du second substrat (2a, 2b,...,2i) auquel il est associé.

8. Procédé selon l'une quelconque des revendications 5 à 7, **caractérisé en ce que** le premier substrat (1) et/ou les seconds substrats (2a, 2b,...,2i) sont des substrats amincis.

## Claims

1. A method for bonding between at least two substrates (1,2, 2a, 2b,..., 2i) comprising:
- a step of deposition of at least one drop of liquid adhesive (8, 8a, 8b,..., 8i) on one of the two substrates (1,2, 2a, 2b,..., 2i),
- and a step of bringing the two substrates (1,2, 2a, 2b, ..., 2i) into contact causing spreading of the liquid adhesive followed by formation of a layer of solidified adhesive (7, 7a, 7b,...,7i) between the two substrates (1,2, 2a, 2b, ..., 2i), **characterized in that**
- one of the two substrates (1,2, 2a, 2b, ..., 2i) is provided, at the surface thereof, with at least one salient rim (3, 3a, 8b,..., 3i) in which at least one slit (4) is formed,
- and the volume of liquid adhesive deposited on one of the two substrates (1,2, 2a, 2b, ..., 2i) is greater than the volume of the bonding space delineated by said rim (3, 3a, 3b,..., 3i) when the substrates (1,2, 2a, 2b, ..., 2i) are brought into contact, so that the excess liquid adhesive is removed via the slit (4) formed in the rim (3, 3a, 3b,..., 3i), when the two substrates (1,2, 2a, 2b, ..., 2i) are brought into contact, the drop of liquid adhesive (8, 8a, 8b,..., 8i) deposited on one of the two substrates (1,2, 2a, 2b, ..., 2i) further presenting a strictly greater height (H2) than the height (H1) of the rim (3, 3a, 3b,..., 3i).

2. The method according to claim 1, **characterized in that** the contacting step of the two substrates (1,2, 2a, 2b, ..., 2i) is performed without exerting any pressure on one or the other of the substrates (1,2, 2a, 2b, ..., 2i).

3. The method according to one of claims 1 to 2, **characterized in that** deposition of at least one drop of liquid adhesive is performed on the substrate (1,2, 2a, 2b, .., 2i) provided with said rim (3, 3a, 3b,..., 3i).

4. The method according to one of claims 1 to 2, **characterized in that** deposition of at least one drop of liquid adhesive is performed on the substrate (1,2, 2a, 2b, ..., 2i) not provided with said rim.

5. The method according to any one of claims 1 to 4, **characterized in that** the method is a method for bonding between a first substrate (1) and a plurality of coplanar second substrates (2, 2a, 2b, ... , 2i) separated by at least one dicing path (9).

6. The method according to claim 5, **characterized in that** said rim (3) is formed at the surface of the first substrate (1).

7. The method according to claim 5, **characterized in that** each second substrate (2, 2a, 2b, ..., 2i) comprises, on the surface thereof, a salient rim (3a, 3b,..., 3i) in which at least one slit (4) is formed, said rim (3a, 3b,..., 3i) being arranged at the periphery of the second substrate (2, 2a, 2b, ... , 2i) with which it is associated.

8. The method according to any one of claims 5 to 7, **characterized in that** the first substrate (1) and/or second substrates (2, 2a, 2b, ..., 2i) are thinned substrates.

## Patentansprüche

1. Klebeverfahren zwischen wenigstens zwei Substraten (1, 2, 2a, 2b,..., 2i), umfassend:
- einen Schritt zum Abscheiden wenigstens eines Tropfens flüssigen Klebers (8, 8a, 8b,..., 8i) auf einem der beiden Substrate (1, 2, 2a, 2b,..., 2i) und
- einen Schritt zum Inkontaktbringen der beiden Substrate (1, 2, 2a, 2b,..., 2i), der das Ausbreiten des flüssigen Klebers bewirkt, an das sich die Bildung einer erstarrten Kleberschicht (7, 7a, 7b,..., 7i) zwischen den beiden Substraten (1, 2, 2a, 2b,..., 2i) anschließt,
**dadurch gekennzeichnet, dass**:
- eines der beiden Substrate (1, 2, 2a, 2b,..., 2i) an der Oberfläche mit wenigstens einem vorspringenden Rand (3, 3a, 3b,..., 3i) versehen ist, in dem wenigstens ein Schlitz (4) ausgebildet ist, und dass
- das auf einem der beiden Substrate (1, 2, 2a, 2b,..., 2i) abgeschiedene Volumen an flüssigem Kleber größer ist als das Volumen des Kleberaums, der durch den Rand (3, 3a, 3b,..., 3i) begrenzt wird, wenn die Substrate (1, 2, 2a, 2b,..., 2i) in Kontakt gebracht werden, so dass der Überschuss an flüssigem Kleber bei Inkontaktbringen der beiden Substrate (1, 2, 2a, 2b,..., 2i) durch den in dem Rand (3, 3a, 3b,..., 3i) ausgebildeten Schlitz (4) abgeführt wird, wobei der auf einem der beiden Substrate (1, 2, 2a, 2b,..., 2i) abgeschiedene Tropfen flüssigen Klebers (8, 8a, 8b,..., 8i) ferner eine Höhe (H2) aufweist, die streng größer als die Höhe (H1) des Randes (3, 3a, 3b,..., 3i) ist.

2. Verfahren nach Anspruch 1, **dadurch gekennzeichnet, dass** der Schritt des Inkontaktbringens der beiden Substrate (1, 2, 2a, 2b,..., 2i) ohne Ausüben eines Druckes auf das eine oder auf das andere der Substrate (1, 2, 2a, 2b,..., 2i) durchgeführt wird.

3. Verfahren nach einem der Ansprüche 1 bis 2, **dadurch gekennzeichnet, dass** das Abscheiden wenigstens eines Tropfens flüssigen Klebers auf dem mit dem Rand (3, 3a, 3b,..., 3i) versehenen Substrat (1, 2, 2a, 2b,..., 2i) vollzogen wird.

4. Verfahren nach einem der Ansprüche 1 bis 2, **dadurch gekennzeichnet, dass** das Abscheiden wenigstens eines Tropfens flüssigen Klebers auf dem Substrat (1, 2, 2a, 2b,..., 2i), das nicht mit dem Rand versehen ist, vollzogen wird

5. Verfahren nach einem der Ansprüche 1 bis 4, **dadurch gekennzeichnet, dass** das Verfahren ein Klebeverfahren zwischen einem ersten Substrat (1) und einer Vielzahl von koplanaren zweiten Substraten (2a, 2b, ... ; 2i), die durch wenigstens einen Schneidweg (9) getrennt sind, ist.

6. Verfahren nach Anspruch 5, **dadurch gekennzeichnet, dass** der Rand (3) an der Oberfläche des ersten Substrats (1) ausgebildet ist.

7. Verfahren nach Anspruch 5, **dadurch gekennzeichnet, dass** jedes zweite Substrat (2a, 2b,..., 2i) an der Oberfläche einen vorspringenden Rand (3a, 3b,..., 3i) aufweist, in dem wenigstens ein Schlitz (4) ausgebildet ist, wobei der Rand (3a, 3b,..., 3i) am Umfang des zweiten Substrats (2a, 2b,..., 2i), dem er zugeordnet ist, angeordnet ist.

8. Verfahren nach einem der Ansprüche 5 bis 7, **dadurch gekennzeichnet, dass** das erste Substrat (1) und/oder die zweiten Substrate (2a, 2b,..., 2i) verjüngte Substrate sind.
